# EUROPÄISCHE PATENTSCHRIFT

(11) **EP 2 004 542 B1**
(45) Veröffentlichungstag und Bekanntmachung des Hinweises auf die Patenterteilung: **11.06.2014**
(21) Anmeldenummer: 07727811.7
(22) Anmeldetag: 04.04.2007
(51) Int. Cl.: B81C 1/00, B81B 7/00, B81B 7/02

(54) **MIKROMECHANISCHE GEHÄUSUNG MIT MINDESTENS ZWEI KAVITÄTEN MIT UNTERSCHIEDLICHEM INNENDRUCK UND/ODER UNTERSCHIEDLICHER GASZUSAMMENSETZUNG SOWIE VERFAHREN ZU DEREN HERSTELLUNG**
MICROMECHANICAL HOUSING COMPRISING AT LEAST TWO CAVITIES HAVING DIFFERENT INTERNAL PRESSURE AND/OR DIFFERENT GAS COMPOSITIONS AND METHOD FOR THE PRODUCTION THEREOF
BOÎTIER MICROMÉCANIQUE COMPORTANT AU MOINS DEUX CAVITÉS PRÉSENTANT DES PRESSIONS INTÉRIEURES ET/OU DES COMPOSITIONS GAZEUSES DIFFÉRENTES ET PROCÉDÉ DE FABRICATION

(30) Priorität: 06.04.2006 DE 102006016260
(43) Veröffentlichungstag der Anmeldung: 24.12.2008
(73) Patentinhaber: Fraunhofer-Gesellschaft zur Förderung der angewandten Forschung e.V., 80686 München (DE)
(72) Erfinder: MERZ, Peter, 25557 Beldorf (DE); REINERT, Wolfgang, 24536 Neumünster (DE); OLDSEN, Marten, 22761 Hamburg (DE); SCHWARZELBACH, Oliver, 25524 Itzehoe (DE)
(74) Vertreter: Leonhard, Frank Reimund
(86) Internationale Anmeldenummer: PCT/EP2007/053342
(87) Internationale Veröffentlichungsnummer: WO 2007/113325

(56) Entgegenhaltungen:
- EP-A- 0 794 558
- US-A1- 2002 171 075
- US-B1- 6 470 594

## Beschreibung

Die vorliegende Erfindung ist auf ein Verfahren gerichtet, das sich für die vorzugsweise auf Waferebene durchgeführte, kombinierte Gehäusung von mikromechanischen Systemen eignet, die einen jeweils unterschiedlichen Betriebsdruck benötigen. Das Verfahren erlaubt im gleichen Arbeitsschritt die selektive Befüllung einer Kavität 1 mit definiertem Gasdruck P1 und einer Kavität 2 mit Gasdruck P2, wobei P1 und P2 voneinander unabhängig gewählt werden können. Mit dem Verfahren lassen sich unterschiedliche mikromechanische Systeme in einem Bauteile kombinieren. Dadurch lässt sich der Integrationsgrad solcher Systeme erheblich steigern. Weiterhin umfasst die Erfindung mikromechanische Systeme mit mindestens zwei Kavitäten, die unterschiedliche Innendrücke und/oder Gaszusammensetzungen aufweisen.

Mit Hilfe der Mikrosystemtechnik gefertigte Bauteile (MEMS) sind seit längerem für die miniaturisierte und kostengünstige Herstellung von Sensoren und Aktoren etabliert. Die Mikrosystemtechnik (MST) ist ein relativ junger Technologiezweig, der sich in großen Teilen die leistungsfähigen Produktionsprozesse der Halbleiterindustrie zu eigen macht, um mit diesen mikrotechnischen Verfahren, die auf den Grundwerkstoff Silizium zugeschnitten sind, makroskopische Technologiesysteme in die Mikrowelt zu übertragen, und so die stetige Miniaturisierung und Leistungssteigerung von technischen Produkten unterstützt. Die mittels MST hergestellten Produkte finden branchenübergreifend Anwendung in der Mikroelektronik, der Industrieautomation, der Kommunikations- und Medizintechnik, in der Automobilindustrie oder auch bei Life Science Produkten. Dabei erfordern die fortschreitende Miniaturisierung sowie die kontinuierliche Erhöhung der technologischen Integrationsdichte von Mikrosystemen eine anhaltende Enfinricklung und Verbesserung von bestehenden Produktionsprozessen.

In der Automobilbranche, aber auch im Maschinenbau besteht Bedarf an komplexen, integriert aufgebauten Mikrosystembauteilen, die vielfältigste Mess- und Regelfunktionen autonom und mit geringem Energiebedarf durchführen. Die unterschiedlichen Sensorsysteme erfordern je nach Auslegung einen entsprechenden Arbeitsdruck. So benötigen resonante Systeme oftmals eine hohe Güte. Daher muss die mechanische Dämpfung durch umgebendes Gas durch einen entsprechenden geringen Arbeitsdruck in der Kavität, in der sich das jeweilige Sensorsystem befindet, minimiert werden. Resonante Drehratensensoren zum Beispiel werden typischerweise mit einem Arbeitsdruck von einem µbar bis einigen mbar betrieben. Beschleunigungssensoren müssen hingegen teilweise stark gedämpft werden, sodass hier der Betriebsdruck in der Regel bei einigen hundert mbar liegt. Folgende Tabelle zeigt für einige verschiedene Mikrosysteme den jeweils typischen Betriebsdruck:

| Sensor/Bauteiltyp | Betriebsdruck |
|---|---|
| Beschleunigungssensor | 300-700 mbar |
| Absolutdrucksensor | 1-10 mbar |
| Resonanter Sensor (z.B. Drehratensensor) | 0,1 mbar |
| Bolometer | < 0,0001 mbar |
| RF Switch | < 0,0001 mbar |

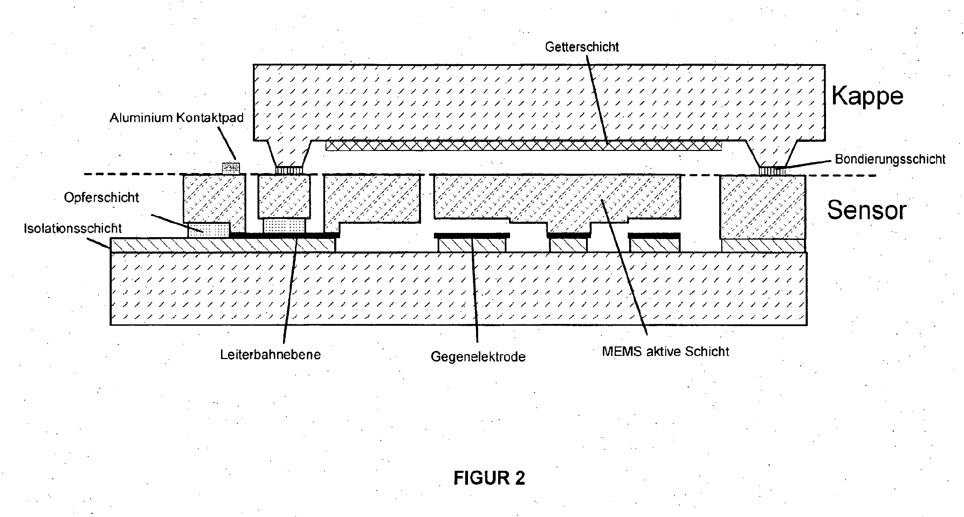

In Fig. 2 ist ein typischer Aufbau eines mikrosystemtechnisch hergestellten, resonanten Inertialsensors dargestellt (P. Merz, W. Reinert, K. Reimer, B. Wagner, 'PSM-X2: Polysilicon surface micromachining process platform for vacuum-packaged sensors, Konferenzband Mikrosystemtechnik-Kongress 2005, D/Freiburg, VDE Verlag, p.467-470). Der unten liegende, oberflächenmikromechanische Sensor enthält die aktive Sensorstruktur (MEMS Active Layer). Durch einen spezifischen Ätzschritt, bei der eine Opferschicht entfernt wird, können freitragende Strukturen hergestellt werden. Für die kapazitive Detektion von Bewegungen aus der Ebene sind in einem Abstand von 1,5 µm Gegenelektroden implementiert. Die Bewegungsrichtung mikromechanischer Systeme ist somit nicht nur auf Bewegungen in der Ebene (in-plane) beschränkt, sondern es können auch out-of plane Bewegungen angeregt und detektiert werden. In dem oberen Deckel-Chip (Cap) ist über der Sensorstruktur eine 60 µm tiefe Kavität eingebracht, in welcher Gettermaterial zur Absorption und chemischen Bindung von Gasmolekülen abgeschieden ist. Die feste Verbindung von Sensor- und Kappenwafer auf Wafer-Ebene, das sog. Wafer-Level Packaging, wird hier durch ein Gold-Silizium Eutektikum bewirkt. Der Bondrahmen aus Gold-Silizium sorgt für eine hermetische Kapselung, so dass der beim eutektischen Verbindungsprozess eingestellte Druck erhalten bleibt. Durch die in der Kavität eingebrachte Getterschicht wird sichergestellt, dass ein minimaler Kavitätsinnendruck von bis zu 1 E-6 bar eingestellt und über die gesamte Lebensdauer des Bauelements erhalten werden kann.

Im Bereich der Mikrosystemtechnik ist die Gehäusung von Mikrosensoren eines der am wenigsten entwickelten, jedoch gleichzeitig eines der wichtigsten und herausforderndsten Technologiefelder. Besonders die Bereitstellung einer hermetischen Gehäusung ist eine Schlüsseltechnologie für viele mikromechanische Komponenten. Durch die hermetische Verkapselung werden Mikrosensoren vor schädlichen Umwelteinflüssen (Staub, mechanischer oder chemischer Schädigung) abgeschirmt und so ihre zuverlässige Funktion und Lebensdauer entscheidend verlängert. Darüber hinaus benötigen moderne resonant betriebene Mikrosensoren ein spezifisches Arbeitsgas oder einen definiert eingestellten Umgebungsdruck in der Gehäusekavität, um die geforderte Funktionalität zu erfüllen.

Beim so genannten Wafer-Level Packaging (WLP) wird die Verkapselung der offenen Sensoren auf Waferebene durchgeführt. Dazu wird ein entsprechender Kappenwafer gefertigt, der die individuellen, funktionellen Elemente der Gehäusung enthält. Der Kappenwafer wird mit dem Sensorwafer gefügt, so dass jeder Sensorchip mit einem entsprechenden Gehäusechip fest verbunden wird. Erst nach dieser Fügung auf Waferebene wird dann das Waferpaar in einzelne Chips vereinzelt. Durch die massiv parallele Arbeitsweise hat die Gehäusung auf Waferebene im Vergleich zu einer Gehäusung auf Chipebene enorme Vorteile in Bezug auf Kosten, Bauteilintegrations dichte und Ausbeute.

Für die WLP Technolgie stehen eine Reihe von etablierten Verfahren zur Verfügung wie zum Beispiel Glass Frit Bonden, anodisches Waferbonden, Direktbonden (Fusion Bonding), Eutektisches Bonden, Thermokompressionsbonden, Adhesives Bonden, oder Kleben (siehe R.F.Wolffenbuttel, K.D.Wise, 'Low-temperature silicon-to-waferbonding using gold at eutectit temperature', Sensors and Actuators A, 43, 1994, p.223-229; M.Madou, 'Fundamentals of Microfabrication', CRC Press, Boca Raton, 2002).

Bei der Gehäusung auf Waferebene werden das in der Prozesskammer befindliche Gas sowie der Prozessdruck in der Kavität eingeschlossen. Dadurch werden alle Bauteile des Wafers im Rahmen der Prozessuniformität mit dem gleichen Kavitätendruck versehen, wobei sowohl Atmosphärendruck, Subatmosphärendruck als auch Überdruck in die Kavität eingeschlossen werden können. In der Regel kann durch die oben erwähnten WLP Technologien ein minimaler Kavitätendruck von 1-10 mbar erreicht werden. Geringere Arbeitsdrücke sind in der Regel nicht einstellbar, da sich ein Restpartialdruck im Bereich von ca. 1 bis 10 mbar durch Materialausgasung, Oberflächendesorption von Molekülen sowie Dekomposition von Kontaminationspartikeln ergibt. Um einen niedrigeren Druckbereich unterhalb 1 mbar zu erreichen, müssen zusätzliche funktionelle Schichten, so genannte Getterschichten (siehe M.Moraja, M.Amiotti, R.C.Kullberg, 'New getter configuration at wafer level for assuring long term stability of MEMS', Proc. of SPIE, Vol. 4980., 2003, p. 260-267; D.Sparks, S.Massoud-Ansari, N. Najafi, 'Reliable vacuum packaging using Nanogetters™ and glass frit bonding', Reliability, Testing and Characterisation of MEMS/MOEMS III, Proc. of SPIE, Vol. 5343, 2004, p. 70-78) eingebaut werden, die gezielt Gasmoleküle absorbieren. Dies kann durch Oberflächenadsorption, durch Löslichkeit im Volumen oder auch durch chemische Bindung erfolgen.

In den letzten Jahrzehnten ist eine große Anzahl von Gettermaterialien entwickelt worden. Zu den bereits seit längerem verwendeten gehören Getter aus Metallen oder Legierungen wie Ba, Al, Ti, Zr, V, Fe und dergleichen, die z.B. bei Kathodenstrahlröhren, Flachbildschirmen, Teilchenbeschleunigern oder Halbleiterverarbeitungs-Ausrüstungen eingesetzt werden, siehe z.B. die US-Patente 4,269,624, 5,320,496, 4,977,035 oder 6,236,156. Diese Materialien ab- oder adsorbieren verschiedene Gase durch Oxid- und Hydridbildung oder einfache Oberflächenadsorption. Sogenannte Non Evaporable Getters (NEGs) wurden ab der Mitte der 90er Jahre des vergangenen Jahrhunderts in Tabletten- oder Streifenform in speziell dafür ausgebildete Vertiefungen oder benachbart zum Chip in einer Umhüllung aus Keramik angebracht. Um den Oberflächenbereich möglichst groß zu machen, werden die NEGs häufig mit Hilfe von pulvermetallurgischen Verfahren hergestellt, in denen das Sintern der Metallteilchen nur gerade initiiert wird, wodurch kleine Zwischenräume zwischen den Metallkügelchen verbleiben. Mit Hilfe eines Temperaturaktivierungs-Schritts im Vakuum oder in einer Wasserstoff enthaltenden, reduzierenden Atmosphäre wird die oberflächliche Oxidschicht entfernt, die sich während des Sinterschritts auf dem Metall gebildet hat. Die Aktivierung wird dann durch durchgehendes Erhitzen der gesamten umgebenden Struktur oder durch Widerstandsheizen (mit einer Ohm'schen Heizung) abgeschlossen.

Die EP 0 794 558 A1 offenbart ein elektronisches Bauelement mit einem Substrat und einer Kappe in Form eines mikroelektromechanischen Systems oder MEMS. Das Bauelement weist einen ersten Haupthohlraum und einen zweiten Hohlraum auf. An den Kontaktbereichen zwischen Substrat und Kappe ist eine hermetische Dichtung ausgebildet. In dem zweiten Hohlraum kann ein Getter angeordnet sein, um dort absichtlich einen Unterdruck zu erzeugen. Außerdem kann in dem zweiten Hohlraum ein Leckdetektor, beispielsweise in Form eines Drucksensors, Feuchtigkeitssensors oder einer korrosionsüberprüfenden Struktur angeordnet sein.

Die US 2005/0023629 A1 offenbart eine Mikrovorrichtung mit einem hermetisch gedichteten Hohlraum zur Aufnahme einer Mikrostruktur. Sie umfasst ein Substrat und eine Kappe. Es sind Isolationsgräben vorgesehen zwischen der Kappe und einer nebenliegenden Kontaktinsel, die ungefüllt oder mit einem isolierenden Material gefüllt sind.

Die WO 2005/050751 A2 offenbart eine Verkappungseinrichtung (Deckel) für elektronische Vorrichtungen mit einem Substrat und einem aktiven Bereich zur im Wesentlichen hermetischen Abdichtung der elektronischen Vorrichtung. Der Deckel weist einen Innenbereich auf, der von einer ersten Barrierestruktur umgeben ist. Um diese erste Barrierestruktur herum ist mit Zwischenraum eine zweite Barrierestruktur angeordnet. In dem Innenbereich und dem Zwischenraum sind erste und zweite Schichten eines Gettermaterials angeordnet.

Die US 2004/0183214 A1 offenbart ein Schichtbauteil mit mehreren aufeinander geschichteten Einzelbauteilen, die jeweils in gesonderten Verfahrensschritten hergestellt wurden. In einem dieser Schichtbauteile liegen zwei Kavitäten mit gleicher Füllung und gleichem Zustand vor.

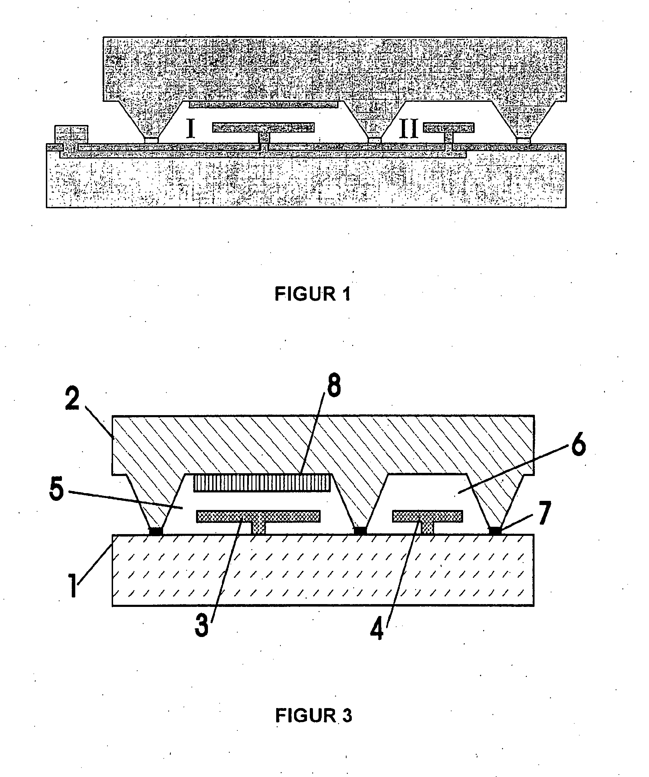

Es ist eine Aufgabe der vorliegenden Erfindung, für die Mikrosystemtechnik vorgesehene Bauteile (MEMS) (z.B. Chips) mit mindestens zwei Kavitäten oder Hohlräumen (I und II in Figur 1) bereitzustellen, deren Gasräume unterschiedliche Drücke und/oder unterschiedliche Gaszusammensetzungen aufweisen. Die Erfindung soll auch Vielfach-Bauelement-Systeme (z.B. Wafer) mit einem Substrat und einer Kappenstruktur bereitstellen, aus denen sich die genannten Bauteile durch Trennen (Sägen oder dgl.) herstellen lassen. Und schließlich soll die Erfindung Verfahren bereitstellen, mit denen sich die genannten Bauteile sowie die Vielfach-Bauelement-Systeme, aus denen sie u.a. gefertigt werden können, herstellen lassen.

Die Aufgabe der Erfindung wird durch ein Verfahren nach Anspruch 7 und ein Bauteil nach Anspruch 1 gelöst. Ein erster der beiden Hohlräume eines (MEMS-)Bauteils ist mit einem (ersten) Gettermaterial versehen und das Bonden von Substrat und Kappe erfolgt in einer Gasatmosphäre, die mindestens eine Gassorte aufweist, die vom ersten Gettermaterial absorbiert werden kann, derart, dass aufgrund der Absorptionseigenschaften des Gettermaterials gegenüber dieser Gassorte nach der Aktivierung des Gettermaterials der erste der beiden Hohlräume einen anderen Innendruck und/oder eine andere Gaszusammensetzung aufweist als ein zweiter Hohlraum. In bevorzugter Weise weist die Gasatmosphäre zwei Gassorten A und B auf, die gegenüber dem (ersten) Gettermaterial unterschiedliche Absorptionseigenschaften besitzen. Der zweite Hohlraum enthält entweder kein Gettermaterial, oder er enthält ein zweites Gettermaterial mit anderen Absorptionseigenschaften, oder er enthält das erste oder ein zweites Gettermaterial in einer Menge, aufgrund der nach Aktivierung des Gettermaterials ein anderes Verhältnis der beiden Gassorten in diesem zweiten Hohlraum entsteht als im ersten Hohlraum.

Für die gleichzeitige, auf Waferebene oder dgl. durchgeführte Gehäusung einer Mehrzahl oder Vielzahl von Mikrosystemen mit aktiven Strukturen, beispielsweise Sensorsystemen, mit unterschiedlichem Arbeitsdruck kann ein entsprechender Wafer oder dgl., der entsprechende aktive Strukturen aufweist, bereitgestell werden, z.B. ein Wafer mit einem oder - in der Regel - mehreren zu gehäusenden Sensoren. In Figur 3 ist beispielhaft hierfür der Aufbau eines Sensorsystems mit zwei Submodulen gezeigt, die jeweils hermetisch voneinander getrennt sind. Auf einem - auf seiner Oberseite im Wesentlichen ebenen - Sensorwafer 1 befinden sich die mikromechanischen Sensorsubsysteme 3,4. Zusätzlich ist eine Abdeckung vorgesehen, z.B. ein Kappenwafer 2, der zur Bereitstellung von Kavitäten in den Sensorbereichen Vertiefungen oder Ausnehmungen aufweist und in einem Bondprozess mit dem Sensorwafer 1 fest verbunden wird. Der Bondrahmen 7 umschließt die Sensorbereiche und dichtet diese hermetisch von der Umgebung ab. Es sollte klar sein, dass die Anordnung der aktiven Strukturen und der Vertiefungen natürlich auch eine andere sein kann als in der Figur gezeigt. Z.B. können die aktiven Strukturen (z.B. Sensoren) in einer Vertiefung des Sensorwafers angeordnet sein, während der Kappenwafer innenseitig je nach Platzbedarf der aktiven Strukturen eben ist oder nur geringfügige Vertiefungen aufweist. Stattdessen kann die aktive Struktur bei Bedarf auch im Kappenwafer angebracht sein, so dass die vorgenannten Varianten spiegelbildlich zu realisieren wären.

Die durch den Bondprozess definierte bzw. für die Zwecke der Erfindung geeignet gewählte Prozessatmosphäre wird beim Verbinden der beiden Wafer in den Kavitäten oder Hohlräumen eingeschlossen. Diese Prozessatmosphäre besteht aus mindestens einer Gassorte A. Wird das erste Gettermaterial im ersten Hohlraum aktiviert, wird diese Gassorte je nach Gettermaterialmenge zumindest teilweise oder aber vollständig oder im Wesentlichen vollständig absorbiert, und in diesem Hohlraum entsteht ein (Teil-)Vakuum. Bevorzugt besteht die Prozessatmosphäre aus mindestens zwei gegenüber dem ersten Gettermaterial unterschiedlich reaktiven Gassorten A und B.

Unter "Gassorte" ist erfindungsgemäß ein einzelnes Gas oder eine Gasmischung zu verstehen. Dieses einzelne Gas oder die Mischungsbestandteile der Gassorte (z.B. A) besitzt/besitzen (alle) zumindest eine Eigenschaft in Hinblick auf die Absorbierbarkeit durch das eingesetzte Gettermaterial, die sich von einer entsprechenden Eigenschaft der (oder einer) jeweils anderen Gassorte (z.B. B) unterscheidet. So kann es sich bei der Gassorte A z.B. um eine Mischung von Gasen ähnlicher oder auch unterschiedlicher Reaktivität handeln, die jedoch alle von dem eingesetzten Gettermaterial absorbiert werden, während die Gassorte B z.B. ausschließlich ein oder mehrere Edelgase enthält, die von Gettermaterialien nicht absorbiert werden.

Wiederum Bezug nehmend auf Figur 3 besitzt, wie bereits erwähnt, entweder der Kappenwafer oder der Wafer, der die aktive Struktur aufweist, eine Vertiefung, so dass beide Wafer unter Ausbildung von Kavitäten gebondet werden können. Für jeweils ein Mikrosystem-Bauteil sind mindestens zwei solcher Kavitäten 5,6 vorgesehen; es können aber natürlich je nach Bedarf auch mehr sein. Vorzugsweise im Kappenwafer wird im Bereich der Vertiefungen innenseitig ein Gettermaterial 8 angebracht, und zwar derart, dass es nach dem Bonden nur in der ersten der mindestens beiden Kavitäten 5,6 vorhanden ist. Das Gettermaterial in der ersten Kavität 5 kann Moleküle einer ersten Gassorte A (z.B. H₂, O₂, CO₂ oder N₂ oder beliebige Mischungen hiervon) absorbieren. Mit Molekülen einer zweiten Gassorte B (z.B. Inertgasen wie Ar oder Ne) weist es in der Regel keine Wechselwirkung auf. Das Gettermaterial wird, wie aus dem Stand der Technik bekannt und einleitend erörtert, meist in einem passiven Zustand im Deckelwafer angebracht. Seine Aktivierung erfolgt üblicherweise durch einen Temperatur-Zeit-Prozess, wie aus dem Stand der Technik bekannt und nachstehend ausführlicher erläutert. Nach dieser Aktivierung werden Moleküle der Sorte A gegettert (absorbiert).

Durch die Aktivierung des Getters können die in den ersten Kavitäten 5 befindlichen Gasspezies der Sorte A absorbiert werden, so dass der Kavitätendruck durch die restlichen Moleküle der Sorte B definiert wird. In den zweiten Kavitäten ohne Gettermaterial verbleibt der ursprüngliche Kavitätendruck, der aus der Summe (den Partialdrücken) der Teilchen A und B gebildet wird. Erfindungsgemäß kann über die Zusammensetzung der ursprünglichen Gasmischung (A+B) und die Menge und die Art des Gettermaterials in mindestens den ersten Kavitäten, das sich von der Menge und/oder der Art des Gettermaterials in den zweiten Kavitäten unterscheiden muss (sofern dort überhaupt Gettermaterial vorhanden sein soll), der Enddruck der verschiedenen Subsysteme eingestellt werden. Es sollte klar sein, dass der Partialdruck der Gassorte B null sein kann. In diesem Falle enthält die Gasmischung nur eine Gassorte A.

In einer ersten Ausgestaltung der Erfindung wird das Gettermaterial in den Deckelbereich der ersten Kavitäten in einer solchen Menge eingebracht, dass die Teilchen der Gassorte A nach der Aktivierung des Getters vollständig oder im Wesentlichen vollständig absorbiert werden. In den ersten Kavitäten 5 befinden sich daher dann (zumindest im Wesentlichen) nur noch Teilchen der Gassorte B (bzw., wenn der Partialdruck von B null oder annähernd null ist, ein mehr oder weniger stark dem Absolutwert angenähertes Vakuum), während alle Gasmoleküle der Sorten A und ggf. B im Gasraum der zweiten Kavitäten 6 verbleiben.

In einer alternativen Ausgestaltung der Erfindung wird das Gettermaterial in einer Menge in den ersten Kavitäten 5 angebracht, die nicht zur vollständigen Absorption der Gassorte A ausreicht, sondern nur eine anteilige Menge von x Mol-% absorbiert. Nach Aktivierung unterscheiden sich die Gasatmosphären der Kavitäten dann dadurch, dass infolge der gewählten, reduzierten Menge an Gettermaterial und der daraus resultierenden unvollständigen Gasabsorption die ersten Kavitäten einen Gasgehalt von (100-x) Mol-% A plus die Gesamtmenge an B aufweisen, während die Gasmischung in den zweiten Kavitäten unverändert bleibt. Auf diese Weise können beliebige Druck-Mischbereiche eingestellt werden.

In einer weiteren Ausgestaltung der Erfindung besitzt das MEMS-Bauteil (z.B. ein Chip) zwei oder auch mehr Kavitäten 5,6, wobei Gettermaterial in den beiden oder, bei Vorhandensein von mehr Kavitäten pro Bauteil, in mindestens zweien der pro Bauteil vorgesehenen Kavitäten vorhanden ist. In diesen Fällen unterscheidet sich die Fläche des Gettermaterials und/oder dessen Gasabsorptionseigenschaft in den beiden Kavitäten voneinander derart, dass nach Aktivierung des Gettermaterials in den beiden oder in den mindestens zwei Kavitäten unterschiedliche Enddrücke herrschen und/oder Gaszusammensetzungen vorhanden sind.

Das Gettermaterial kann in beliebiger Form, z.B. als Streifen oder Fläche, in der Kavität angeordnet sein, es kann aber auch eine strukturierte Gestalt besitzen. In günstiger Weise wird es auf der Kappenseite des Wafers oder dgl. angebracht, z.B. in dessen Vertiefungen, sofern diese dort vorgesehen sind. Alternativ kann sich das Gettermaterial aber auch auf der Substratseite befinden, z.B. seitlich der aktiven Strukturen oder sogar darunter, sofern die entsprechenden Flächen nicht anderweitig benötigt werden.

Wenn das herzustellende Bauteil mehr als zwei Kavitäten aufweisen soll, kann die Gasmischung wiederum aus zwei Gassorten A und B bestehen, wobei z.B. in den ersten Kavitäten ein Gettermaterial in einer solchen Menge angeordnet ist, dass die Gassorte A nach Aktivierung ganz oder teilweise absorbiert wird, während in den zweiten Kavitäten ein Gettermaterial angeordnet ist, das die Gassorte A zu einem anderen Prozentsatz aus der Mischung (A+B) absorbiert als das erste Gettermaterial, und dritte Kavitäten kein Gettermaterial aufweisen. Alternativ kann die Gasmischung aber auch aus drei oder sogar mehr Gassorten A, B, C ... bestehen. Dann ist es vorteilhaft, in der ersten Kavität ein Gettermaterial mit einer gegenüber der Gasmischung ersten Absorptionseigenschaft und in der zweiten Kavität ein Gettermaterial mit einer gegenüber der Gasmischung zweiten Absorptionseigenschaft anzuordnen. Eine Gasmischung kann beispielsweise aus den Gassorten CO₂, N₂ und Ar bestehen. Ein Gettermaterial mit einer ersten Absorptionseigenschaft bindet Kohlendioxid, jedoch Stickstoff nicht oder nur in geringem Maße. Ein Gettermaterial mit einer zweiten Absorptionseigenschaft bindet Stickstoff und Kohlendioxid. Eine dritte Kavität kann frei von Gettermaterial bleiben.

Die Herstellung der MEMS-Bauteile erfolgt, wie bereits erwähnt, vorzugsweise auf Mehrfachbauelement-, z.B. auf Waferebene, worauf der Wafer oder das sonstige Mehrfachbauelement in die einzelnen Bauteile (z.B. Chips) getrennt wird. Alternativ können die Bauteile natürlich auch einzeln aus einem geeigneten, die aktive(n) Struktur(en) tragenden Einzelsubstrat (z.B. als Basischip) und einem die mindestens zwei Kavitäten 5,6 abdeckenden und dabei gleichzeitig voneinander hermetisch trennenden Deckelteil (z.B. Kappenchip) erzeugt werden.

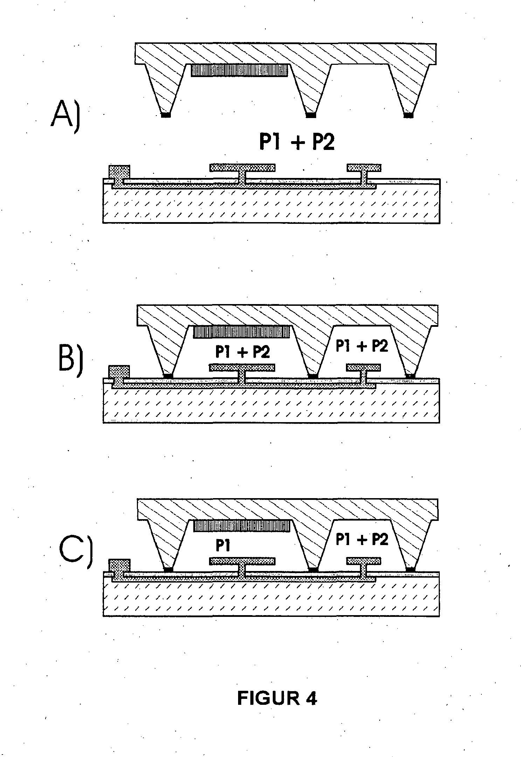

Nachstehend soll das erfindungsgemäße Verfahren beispielhaft und unter Bezugnahme auf die Figuren 4A)-4C) anhand der Herstellung eines Wafers mit einer Mehr- oder Vielzahl von Sensoren und der späteren Vereinzelung der MEMS-Bauteile erläutert werden. Es sollte aber klar sein, dass anstelle eines Sensors jede beliebige aktive Struktur vorhanden sein kann, die man in der Mikrosystemtechnik benötigt, z.B. Aktuatoren, Resonatoren, Displays, digitale Mikrospiegel, Bolometer, RF Switchs und andere. Als Sensor kann ebenfalls jeder beliebige Sensor vorgesehen sein, z.B. ein Drehratensensor (resonanter Sensor, Gyroskop), ein Beschleunigungssensor, ein Absolutdrucksensor oder dergleichen. Und schließlich sei nochmals darauf hingewiesen, dass anstelle eines (Silizium-)Wafers beliebige andere Substrat- und Kappenmaterialien bzw. Strukturen eingesetzt werden können, die sich für die Herstellung von MEMS-Bauteilen eignen.

Das beispielhafte Verfahren umfasst die folgenden Schritte:
1) Ein in selektiven Bereichen mit Gettermaterial beschichteter Kappenwafer wird bereitgestellt und zu einem Sensorwafer justiert. Durch einen Halterungsmechanismus wird er in einem bestimmten Abstand fixiert.
2) Vor oder nach der Justierung wird das Waferpaar in eine Prozesskammer eingebracht (Fig.4-A)
3) Die Prozesskammer wird mit dem Prozessgas geflutet, welches sich aus einer beliebigen Mischung aus Gassorte A und B (und ggf. C oder weitere) zusammensetzt, welche in den Partialdrücken P1, P2,... vorliegen. Gassorte A kann bei entsprechender Getteraktivierung vom Getter absorbiert werden. Gassorte B wird z.B. nicht gegettert.
4) Der Kappenwafer wird abgesenkt und mit Druckkraft gegen den Sensorwafer gepresst (Fig.4-B)
5) Der Bondvorgang wird durchgeführt. Bei einer eutektischen Bondung befindet sich z.B. auf dem Kappenwafer ein Goldrahmen, der mit dem Silizium des gegenüberliegenden Wafers einen Flächenkontakt bildet. Durch Erhöhung der Temperatur über den eutektischen Punkt hinaus wird die flüssige eutektische Phase, bestehend aus 81 Atom-% Gold und 19 Atom-% Si, gebildet. Beim Abkühlen erstarrt die flüssige Phase. Der Sensor- und der Kappenwafer sind fest miteinander verbunden, wobei der entstandene Bondrahmen gasdicht ist. In beiden Kavitäten ist nun die gleiche Gasmischung eingeschlossen.
6) Durch eine entsprechende Getteraktivierung (Fig.4-C), die in der Regel durch eine Temperaturbehandlung gemäß Stand der Technik nach den Empfehlungen des Herstellers erfolgt, wird das Gettermaterial in einen Zustand gebracht, bei dem es Moleküle der Gassorte A bindet. Unter Umständen kann dies auch während des Bondprozesses erfolgen. Aus den mit Gettermaterial versehenen Kavitäten wird durch die Aktivierung des Getters somit die Gassorte A evakuiert. Es bleiben nur die Gasmoleküle der Sorte B übrig. Der ursprüngliche Kavitätendruck P1+P2 wird auf den Restdruck P2 reduziert. In der nicht mit Gettermaterial versehenen Kavitäten bleibt der ursprüngliche Kavitätendruck P1+P2 erhalten.
7) Nach erfolgter Prozessierung wird im Falle des Vielfach-Bauelements der Wafer in die einzelnen Sensorsysteme (Chips), auf denen die verschiedenen Subsystemen enthalten sind, aufgeteilt, z.B. zersägt.

Eine Ausgestaltung, die nicht zur Erfindung gehört, betrifft insbesondere ein Vielfach-Bauelement, vorgesehen zum späteren Vereinzeln unter Ausbildung aktive Strukturen enthaltender Bauteile, wobei das Vielfach-Bauelement ein flächiges Substrat und eine ebenfalls flächig ausgebildete Kappenstruktur aufweist, die so miteinander verbunden sind, dass sie mindestens einen ersten (5) und einen zweiten Hohlraum (6) pro genanntem Bauteil umschließen, die gegeneinander und gegen die Außenumgebung abgedichtet sind, wobei wenigstens in dem ersten Hohlraum (5) ein Drehratensensor, Beschleunigungssensor, Aktuator, Resonator, Display, digitaler Mikrospiegel, Bolometer und/oder RF-Switch angeordnet ist, wobei der erste (5) der beiden Hohlräume mit einem Gettermaterial (8) versehen ist und aufgrund dieses Gettermaterials einen anderen Innendruck und/oder eine andere Gaszusammensetzung aufweist als der zweite Hohlraum (6).

In einer nicht erfindungsgemäßen Ausführungsform ist dieses Vielfach-Bauelement dadurch gekennzeichnet, dass das flächige Substrat und/oder die flächig ausgebildete Kappenstruktur ein Silizium-Wafer ist. Bei einem Vielfach-Bauelement nach einer der vorbeschriebenen Ausführungsformen kann die obere Oberfläche des flächigen Substrats mit Ausnahme vorhandener aktiver Substanzen eben sein und die flächig ausgebildete Kappenstruktur innenseitige Ausnehmungen oder Vertiefungen aufweisen. Des Weiteren kann bei einem Vielfach-Bauelement nach einer der vorbeschriebenen Ausführungsformen der zweite der beiden Hohlräume kein Gettermaterial enthalten. Alternativ kann der zweite der beiden Hohlräume ein zweites Gettermaterial enthalten, dessen Gasabsorptionseigenschaften sich von denen des Gettermaterials in dem ersten Hohlraum unterscheiden, oder der zweite der beiden Hohlräume dasselbe Gettermaterial wie der erste Hohlraum enthalten, jedoch in einer geringeren Menge bzw. Fläche, bezogen auf das Volumen des Hohlraums. Auch kann bei einem Vielfach-Bauelement nach einer der vorbeschriebenen Ausführungsformen das Gettermaterial zumindest in Teilbereichen strukturiert vorliegen. Schließlich können bei einem Vielfach-Bauelement nach einer der vorbeschriebenen Ausführungsformen das flächige Substrat und die ebenfalls flächig ausgebildete Kappenstruktur durch einen hermetisch schließenden Bondrahmen miteinander verbunden sein.

Eine nicht zur Erfindung gehörende Ausführungsform betrifft des Weiteren ein flächiges Substrat oder eine flächig ausgebildete Kappenstruktur für den Einsatz in einem Vielfach-Bauelement, das zum späteren Vereinzeln unter Ausbildung aktive Strukturen enthaltender Bauteile vorgesehen ist, wobei die Substrat- oder Kappenstruktur erste Ausnehmungen oder Vertiefungen und zweite Ausnehmungen oder Vertiefungen besitzt, jeweils mit einer solchen Gestalt, dass beim Verbinden des Substrats oder der Kappenstruktur mit einem Gegenelement unter Ausbildung des genannten Vielfach-Bauelements gegeneinander abgedichtete Hohlräume entstehen, wobei mindestens in jedem der ersten Bereiche, Ausnehmungen oder Vertiefungen ein Drehratensensor, Beschleunigungssensor, Aktuator, Resonator, Display, digitaler Mikrospiegel, Bolometer und/oder RF-Switch angeordnet ist, wobei sich in den ersten Bereichen, Ausnehmungen oder Vertiefungen ein erstes Gettermaterial befindet, nicht aber in den zweiten Bereichen oder Ausnehmungen, oder dass sich in den zweiten Bereichen oder Ausnehmungen ein zweites Gettermaterial befindet, dessen Gasabsorptionseigenschaften sich von denen des ersten Gettermaterials unterscheidet. Bei dieser Substrat- oder Kappenstruktur sind in einer Ausführungsform sowohl die ersten als auch die zweiten Bereiche, Vertiefungen oder Ausnehmungen vollständig von einem Bondrahmen, vorzugsweise aus Gold, umgeben.

Bei dem zuvor beschriebenen Verfahren kann Verbinden der beiden Wafer mit Hilfe einer hermetischen Bondung erfolgen. Das Verbinden der beiden Wafer kann in demselben Schritt wie das Aktivieren des Gettermaterials erfolgen. Auch kann das Verbinden des Paars aus flächigem Substrat und flächig ausgebildeter Kappenstruktur mit Hilfe einer eutektischen Bondung erfolgen. Dabei kann die flächig ausgebildete Kappenstruktur oder das flächige Substrat vor dem In-Kontakt-Bringen zum Zwecke des späteren Bondens mit einem Goldrahmen versehen werden.

Das Verhältnis der Partialdrücke der in Schritt (d) eingesetzten Gassorten A und B kann zwischen 1:99 und 99:1, vorzugsweise zwischen 1:95 und 95:1 betragen. Bei der letztgenannten Alternative kann die Gassorte A ausgewählt sein unter den Gasen H₂, O₂, CO₂, Methan und N₂ oder einer beliebigen Mischung hiervon, und/oder die Gassorte B ausgewählt sein unter Helium, Neon, Argon, Krypton und Xenon oder einer beliebigen Mischung hiervon.

Bei den im vorstehenden Absatz beschriebenen Ausführungsformen ist es möglich, dass der zweite Hohlraum des genannten Bauteils kein Gettermaterial aufweist. Beträgt das Verhältnis der Partialdrücke der in Schritt (d) eingesetzten Gassorten A und B zwischen 1:99 und 99:1, vorzugsweise zwischen 1:95 und 95:1, kann der zweite Hohlraum ein zweites Gettermaterial mit einer anderen Absorptionseigenschaft gegenüber mindestens einem der Gassorten A und B aufweisen, als sie das erste Gettermaterial besitzt. Alternativ kann in diesem Fall der zweite Hohlraum dasselbe Gettermaterial wie der erste Hohlraum aufweisen, das Gettermaterial jedoch in einer solchen Menge oder Fläche eingebracht sein, dass sich nach Aktivierung des Gettermaterials im zweiten Hohlraum ein anderes Partialdruckverhältnis von P_{A} zu P_{B} einstellt als im ersten Hohlraum.

Bei den zuvor beschriebenen Ausführungsformen kann ein Bauteil mit drei oder mehr Hohlräumen hergestellt werden, wobei der dritte Hohlraum kein Gettermaterial aufweist. In einer Ausführungsform dieses Verfahrens kann der dritte Hohlraum das zweite Gettermaterial mit einer anderen Absorptionseigenschaft gegenüber mindestens einem der Gassorten A und B aufweisen, als sie das erste Gettermaterial besitzt, oder der dritte Hohlraum kann ein drittes Gettermaterial aufweisen, das eine andere Absorptionseigenschaft gegenüber mindestens einem der Gassorten A und B aufweist, als sie das erste Gettermaterial und das zweite Gettermaterial besitzen. Bei den beiden letztgenannten Ausführungsformen kann das Prozessgas zusätzlich eine weitere Gassorte C aufweisen, die von dem zweiten oder dem dritten Gettermaterial nicht oder in substantiell geringerem Ausmaß absorbiert werden kann, wobei die Gassorte A mit dem Partialdruck P_{A}, die Gassorte B mit dem Partialdruck P_{B} und die Gassorte C mit dem Partialdruck P_{C} vorliegt.

Nachstehend soll die Erfindung anhand von Beispielen für verschiedene Gasmischungen näher erläutert werden.

Beispiel A): Die Bondkammer wird mit reinem Gas der Sorte A (z.B. Stickstoff) mit Druck P1 gefüllt.

| | Kammer mit Getter: | Kammer ohne Getter |
|---|---|---|
| Vor der Getteraktivierung | Sticktoff mit Partialdruck P1 P=P1 | Sticktoff mit Partialdruck P1 P=P1 |
| Nach der Getteraktivierung | Stickstoff wird durch Getter gebunden | |
| Theoretischer Kavitätendruck | P=0 | P=P1 |
| Tatsächlich erreichbarer Kavitätendruck | P=1 E-6 bar (Restdruck durch Kontamination verursacht) | P=P1 +/- 1 E-3 mbar |

Beispiel B): Die Bondkammer wird mit einem Mischgas bestehend aus einer Gasmenge der Sorte A (z.B. Stickstoff) mit dem Partialdruck P1 sowie einer Gasmenge der Sorte B (z.B. Argon) mit dem Partialdruck P2 gefüllt:

| | Kammer mit Getter: | Kammer ohne Getter |
|---|---|---|
| Vor der Getteraktivierung | Stickstoff mit Partialdruck P1 | Stickstoff mit Partialdruck P1 |
| | Argon mit Partialdruck P2 | Argon mit Partialdruck P2 |
| | P=P1+P2 | P=P1+P2 |
| Nach der Getteraktivierung | Stickstoff wird durch Getter gebunden Argon verbleibt | Stickstoff mit Partialdruck P1 |
| | | Argon mit Partialdruck P2 |
| Theoretischer Kavitätendruck | P=P2 | P=P1+P2 |
| Tatsächlich erreichbarer Kavitätendruck | P=P2 +/- 1 E-6 bar | P=P1+P2 +/- 1E-6 mbar |

Als Beispiel sei ein Prozessgas aus 4 mbar N₂ und 0.2 mbar Ar ausgegeben. In der Kammer mit Getter herrscht dann nach dessen Aktivierung ein Gesamtdruck von 0.2 mbar, in der Kammer ohne Getter von 4.2 mbar.

In beiden Fällen ist zudem das Gas zu berücksichtigen, das durch Kontamination, Oberflächendesorption und Materialausgasung eingebracht wird. Dieses Gas kann bezüglich seiner Absorptionseigenschaften einer der Gassorten zugeordnet werden und ist hinsichtlich seiner Menge bei dieser zu berücksichtigen.

Das erfindungsgemäße Verfahren besitzt eine Reihe von Vorteilen:
1) Durch die Möglichkeit, eine Gaskomposition aus den Gassorten A und B (plus ggf. C, ...) in beliebiger Zusammensetzung zu mischen, kann in weiten Grenzen ein beliebiger, definierter Betriebsdruck eingestellt werden. Dadurch können in einfacher Weise erste und zweite, ggf. sogar noch dritte oder weitere Kavitäten in dem Wafer bzw. in dem MEMS-Bauteil unterschiedliche Drücke und/oder unterschiedliche Gaszusammensetzungen erhalten. Die Notwendigkeit unterschiedlicher Drücke in den verschiedenen Kavitäten wurde für einige Arten von Bauteilen bereits einleitend erläutert. Die Fähigkeit, unterschiedliche Gaszusammensetzungen in ersten und zweiten Kavitäten zu erzeugen, kann ebenfalls vorteilhaft sein, beispielsweise dann, wenn die eine Kavität mit einem Material ausgekleidet ist, auf das ein bestimmtes Gas eine unerwünschte chemische Einwirkung hat, während eine oder die zweite weitere Kavität gerade dieses Gas zum Erzielen der Wirkung der darin vorhandenen aktiven Struktur benötigt, z.B. in Systemen mit optisch aktiven Gasen als Sperrfilter (Messsensor und Referenz).

Durch die integrierte Gehäusung von zwei oder mehreren Sensortypen mit unterschiedlichem Betriebsdruck auf einem Wafer können folgende Vorteile erzielt werden:
- Eine höhere Integrationsdichte ist erreichbar. Bei einer individuellen Prozessierung der unterschiedlichen Sensorsubsysteme sind periphere Flächen wie Sägestrasse, zusätzliche Bondpads, Sicherheitsabstände etc. zu berücksichtigen. Diese fallen bei einem kombinierten Design weg. Dadurch lässt sich der Anteil der effektiv nutzbaren Fläche erheblich vergrößern.
- Die Justage der unterschiedlichen Submodule ist durch die Lithographieverfahren schon hochpräzise auf Waferebene enthalten. Eine nachträgliche Justage der Submodule entfällt. Nur das Gesamtsystem muss justiert eingebaut werden.

## Patentansprüche

1. **In der Mikrosystemtechnik einsetzbares Bauteil** mit einem Substrat und einer Kappenstruktur,
die so miteinander verbunden sind, dass sie mindestens einen ersten und einen zweiten Hohlraum umschließen,
die gegeneinander und gegen die Außenumgebung abgedichtet sind,
wobei wenigstens in dem ersten Hohlraum (5) ein Drehratensensor, Beschleunigungssensor, Aktuator, Resonator, Display, digitaler Mikrospiegel, Bolometer und/oder RF-Switch angeordnet ist,
**dadurch gekennzeichnet, dass**
der erste der beiden Hohlräume mit einem Gettermaterial versehen ist und aufgrund dieses Gettermaterials einen anderen Innendruck und/oder eine andere Gaszusammensetzung aufweist als der zweite Hohlraum.

2. Bauteil nach Anspruch 1, **dadurch gekennzeichnet, dass** der zweite der beiden Hohlräume kein Gettermaterial enthält.

3. Bauteil nach Anspruch 1, **dadurch gekennzeichnet, dass** der zweite der beiden Hohlräume ein zweites Gettermaterial enthält, dessen Gasabsorptionseigenschaften sich von denen des Gettermaterials in dem ersten Hohlraum unterscheidet.

4. Bauteil nach Anspruch 1, **dadurch gekennzeichnet, dass** der zweite der beiden Hohlräume dasselbe Gettermaterial wie der erste Hohlraum enthält, jedoch in einer geringeren Menge bzw. Fläche, bezogen auf das Volumen des Hohlraums.

5. Bauteil nach einem der Ansprüche 1 bis 4, **dadurch gekennzeichnet, dass** das Gettermaterial zumindest in Teilbereichen strukturiert vorliegt.

6. Bauteil nach einem der Ansprüche 1 bis 5, **dadurch gekennzeichnet, dass** das Substrat und die Kappenstruktur durch einen hermetisch schließenden Bondrahmen miteinander verbunden sind.

7. Verfahren zum Herstellen eines Bauteils wie in einem der Ansprüche 1 bis 6 definiert, umfassend die folgenden Schritte:
a) Bereitstellen eines in den Bereichen des ersten Hohlraums mit einem ersten Gettermaterial beschichteten flächigen Substrats oder einer solchen, ggf. flächig ausgebildeten Kappenstruktur,
b) Justieren des flächigen Substrats oder der Kappenstruktur zu einem entsprechenden Kappen- oder Substrat-Gegenstück,
c) Einbringen des Paars aus flächigem Substrat und ggf. flächig ausgebildeter Kappenstruktur in eine Prozesskammer,
d) Fluten der Prozesskammer mit einem Prozessgas, enthaltend eine oder bestehend aus einer Gassorte A, die von dem oder einem ersten Gettermaterial absorbiert werden kann, und ggf. einer Gassorte B, die von diesem Gettermaterial nicht oder in substantiell geringerem Ausmaß absorbiert werden kann, wobei die Gassorte A mit dem Partialdruck P_{A} und Gassorte B mit dem Partialdruck P_{B} vorliegt,
e) In-Kontakt-Bringen von Kappenstruktur und Substrat und Verbinden dieser beiden Teile mit Hilfe einer geeigneten Verbindungstechnik,
f) Aktivieren des ersten Gettermaterials derart, dass es Moleküle der Gassorte A absorbiert.

8. Verfahren nach Anspruch 7, wobei das Verhältnis der Partialdrücke der in Schritt (d) eingesetzten Gassorten A und B zwischen 1:99 und 99:1, vorzugsweise zwischen 1:95 und 95:1 beträgt.

9. Verfahren nach Anspruch 7 oder 8 wobei das Prozessgas zusätzlich eine weitere Gassorte C aufweist, die von einem zweiten oder einem dritten Gettermaterial nicht oder in substantiell geringerem Ausmaß absorbiert werden kann, wobei die Gassorte A mit dem Partialdruck P_{A}, die Gassorte B mit dem Partialdruck P_{B} und die Gassorte C mit dem Partialdruck P_{C} vorliegt.

## Claims

1. **A component usable in micro-systems technology** including a substrate and a cap structure,
connected to each other in such a manner that they enclose at least a first and a second cavity,
sealed against each other and against the outer environment,
wherein a rotation rate sensor, acceleration sensor, actuator, resonator, display, digital micro-mirror, bolometer and/or HF switch is/are arranged at least in the first cavity (5),
**characterized in that**
the first of said two cavities is provided with a getter material and, due to this getter material, has a different internal pressure and/or a different gas composition than the second cavity.

2. The component according to claim 1, **characterized in that** the second of said two cavities contains no getter material.

3. The component according to claim 1, **characterized in that** the second of said two cavities contains a second getter material, the gas absorption properties of which differ from those of the getter material in the first cavity.

4. The component according to claim 1, **characterized in that** the second of said two cavities contains the same getter material as the first cavity, however, in a lower amount or a smaller area in relation to the volume of the cavity.

5. The component according to any one of claims 1 to 4, **characterized in that** the getter material is present, at least in partial areas, in a structured manner.

6. The component according to any one of claims 1 to 5, **characterized in that** the substrate and the cap structure are connected to each other by a hermetically closing bonding frame.

7. **A method** for manufacturing a component as defined in any one of claims 1 to 6 comprising the following steps:
(a) providing a planar substrate coated, in the areas of the first cavity, with a first getter material or such a cap structure possibly configured in a planar manner,
(b) adjusting the planar substrate or cap structure with respect to a corresponding cap or substrate counterpart,
(c) introducing the pair of planar substrate and cap structure possibly configured in a planar manner into a process chamber,
(d) flooding the process chamber with a process gas comprising or consisting of a type A gas, which can be absorbed by the or a first getter material, and possibly a type B gas, which cannot be absorbed by this getter material or to a substantially lesser degree, wherein the type A gas is present at partial pressure P_{A} and the type B gas is present at partial pressure P_{B},
(e) contacting cap structure and substrate and connecting said two parts by means of a suitable connection technique,
(f) activating the first getter material in such a manner that it absorbs molecules of the type A gas.

8. The method according to claim 7, wherein the ratio of the partial pressures of type A and type B gases employed in step (d) is between 1:99 and 99:1, preferably between 1:95 and 95:1.

9. The method according to claim 7 or 8, wherein the process gas additionally comprises a further type C gas, which cannot be absorbed by a second or third getter material or to a substantially lesser degree, wherein the type A gas is present at partial pressure P_{A}, the type B gas is present at partial pressure P_{B}, and the type C gas is present at partial pressure P_{C}.

## Revendications

1. **Composant utilisable en technique de microsystème,** comportant un substrat et une structure de coiffe,
qui sont reliés l'un à l'autre de manière à enfermer au moins une première et une seconde cavités,
qui sont étanchées l'une par rapport à l'autre et par rapport à l'extérieur,
au moins dans la première cavité (5) étant agencé un capteur de vitesse de rotation, un capteur d'accélération, un actionneur, un résonateur, un écran d'affichage, un micro-miroir numérique, un bolomètre et/ou un commutateur RF, **caractérisé en ce que**
la première des deux cavités est pourvue d'un matériau getter et, en raison de ce matériau getter, elle présente une pression intérieure et/ou une composition gazeuse différente(s) de celle de la seconde cavité.

2. Composant selon la revendication 1, **caractérisé en ce que** la seconde des deux cavités ne comprend pas de matériau getter.

3. Composant selon la revendication 1, **caractérisé en ce que** la seconde des deux cavités comprend un second matériau getter dont les caractéristiques d'absorption de gaz diffèrent de celles du matériau getter dans la première cavité.

4. Composant selon la revendication 1, **caractérisé en ce que** la seconde des deux cavités comprend le même matériau getter que la première cavité, mais dans une quantité ou surface réduite par rapport au volume de la cavité.

5. Composant selon l'une des revendications 1 à 4, **caractérisé en ce que** le matériau getter se présente sous forme structurée au moins dans des zones partielles.

6. Composant selon l'une des revendications 1 à 5, **caractérisé en ce que** le substrat et la structure de coiffe sont reliés entre eux par un cadre de fixation fermant hermétiquement.

7. **Procédé** de fabrication d'un composant tel que défini dans l'une des revendications 1 à 6, comprenant les étapes suivantes :
(a) on prépare un substrat plan revêtu d'un premier matériau getter dans les zones de la première cavité, ou bien une telle structure de coiffe le cas échéant de forme plane,
(b) on ajuste le substrat plan ou la structure de coiffe par rapport à un élément de coiffe ou de substrat complémentaire correspondant,
(c) on introduit dans une chambre de traitement l'appariement constitué du substrat plan et de la structure de coiffe éventuellement plane,
(d) on remplit la chambre de traitement d'un gaz de traitement comprenant ou constitué d'un type de gaz A susceptible d'être absorbé par le ou un premier matériau getter, et le cas échéant d'un type de gaz B qui ne peut pas être absorbé par ce matériau getter, ou bien peut être absorbé seulement d'une ampleur substantiellement réduite, le type de gaz A se présentant à la pression partielle P_{A} et le type de gaz B se présentant à la pression partielle P_{B},
(e) on met en contact la structure de coiffe et le substrat et on relie ces deux éléments à l'aide d'une technique de liaison appropriée,
(f) on fait activer le premier matériau getter de manière à absorber des molécules du type de gaz A.

8. Procédé selon la revendication 7, dans lequel la relation des pressions partielles des types de gaz A et B utilisés dans l'étape (d) est comprise entre 1:99 et 99:1, de préférence entre 1:95 et 95:1.

9. Procédé selon la revendication 7 ou 8, dans lequel le gaz de traitement présente en supplément un autre type de gaz C qui ne peut pas être absorbé par un second ou un troisième matériau getter, ou bien peut être absorbé seulement d'une ampleur substantiellement réduite, le type de gaz A se présentant à la pression partielle P_{A}, le type de gaz B se présentant à la pression partielle P_{B} et le type de gaz C se présentant à la pression partielle P_{C}.
